# FASCICULE DE BREVET EUROPEEN

(11) **EP 1 699 951 B1**
(45) Date de publication et mention de la délivrance du brevet: **12.11.2008**
(21) Numéro de dépôt: 04787441.7
(22) Date de dépôt: 24.09.2004
(51) Int. Cl.: C30B 25/18, C30B 29/40, H01L 21/20

(54) **PROCEDE DE REALISATION DE SUBSTRATS AUTOSUPPORTES DE NITRURES D'ELEMENTS III PAR HETERO EPITAXIE SUR UNE COUCHE SACRIFICIELLE**
VERFAHREN ZUR HERSTELLUNG VON SELBSTTRAGENDEN SUBSTRATEN, DIE III-NITRIDE UMFASSEN, MITTELS HETEROEPITAXIE AUF EINER OPFERSCHICHT
METHOD OF PRODUCING SELF-SUPPORTING SUBSTRATES COMPRISING III-NITRIDES BY MEANS OF HETEROEPITAXY ON A SACRIFICIAL LAYER

(30) Priorité: 26.09.2003 FR 0311296
(43) Date de publication de la demande: 13.09.2006
(73) Titulaire: CENTRE NATIONAL DE LA RECHERCHE SCIENTIFIQUE (CNRS), 75016 Paris (FR)
(72) Inventeur: FELTIN, Eric, Pascal, F-06610 La Gaude (FR); BOUGRIOUA, Zahia, F-06000 Nice (FR); NATAF, Gilles, F-06220 Golfe Juan (FR)
(74) Mandataire: Ahner, Francis
(86) Numéro de dépôt international: PCT/FR2004/002416
(87) Numéro de publication internationale: WO 2005/031045

(56) Documents cités:
- EP-A- 1 041 610
- EP-A- 1 245 702
- EP-A- 1 246 233
- WO-A-96/41906
- WO-A-03/062507
- US-A- 5 919 305
- US-A- 6 071 795
- US-A- 6 146 457
- US-A1- 2001 022 154
- US-A1- 2002 182 889
- US-A1- 2003 024 472
- US-B1- 6 559 075

## Description

La présente invention concerne l'élaboration de substrats autosupportés de nitrures d'éléments III, et notamment de nitrure de gallium.

Alors que les nitrures d'éléments III sont utilisés depuis plus de 10 ans pour la fabrication de dispositifs optoélectroniques, il n'existe à l'heure actuelle aucune source commerciale pour des substrats autosupportés de nitrures d'éléments III (GaN, AlN, InN, ...).

Un substrat autosupporté (en anglais « free standing ») est un substrat d'une épaisseur telle qu'il ne nécessite pas de support pour être utilisé dans la fabrication de composants optoélectroniques et électroniques.

L'hétéro-épitaxie reste encore l'unique solution pour la fabrication de composants à base de nitrure d'élément III. Les substrats utilisés industriellement pour l'épitaxie de nitrure de gallium sont le saphir 0(Al₂O₃) et le carbure de silicium (SiC). Les différences de paramètres de maille et de coefficients d'expansion thermique entre ces substrats et le nitrure d'élément III ont pour conséquence la formation de nombreux défauts dans les couches épitaxiées, ce qui dégrade les performances des composants électroniques réalisés avec ces matériaux. Lorsque le substrat est du saphir, des techniques ont été mises au point, qui consistent à intercaler entre le substrat et la couche épitaxiale de nitrure d'élément III une couche de nucléation, par exemple formée de GaN ou d'AlN déposée avec des conditions de croissance distinctes. Ce traitement de surface permet de limiter la densité de défauts.

Diverses techniques sont actuellement en développement, qui visent à fournir des solutions à la séparation du substrat initial de la couche épitaxiale de nitrure d'élément III pour obtenir des substrats autosupportés. De tels substrats autosupportés de GaN présentent typiquement une épaisseur de 300 µm.

Parmi ces techniques et outre le polissage, on peut notamment citer la séparation par voie chimique. Le document EP 1 041 610 divulgue ainsi une telle technique, adaptée à des substrats spécifiques de type Si, NdGaO₃ ou GaAs. De même, le document US2003/0014472 décrit une technique mettant en oeuvre une attaque chimique dans le cas particulier d'un substrat en LiALO₂. Toutefois, cette technique n'est pas applicable pour un substrat de saphir, qui est chimiquement inerte. De plus, l'utilisation de substrats qui peuvent être attaqués chimiquement (silicium, GaAs, spinelle, ...) ne sont pas toujours compatibles avec les techniques d'épitaxie classiquement utilisées pour le dépôt de couches épaisses de nitrures d'éléments III. Par exemple, l'utilisation de substrats de silicium résulte en l'apparition d'une contrainte thermique en tension dans les couches de nitrure de gallium. Cette dernière est responsable de la formation de fissures. Qui plus est le silicium n'est pas stable thermiquement aux températures d'épitaxie habituelles.

Des procédés faisant intervenir une étape intermédiaire d'attaque chimique ont également été décrits ; cette attaque étant destinée à éliminer des couches intercalaires ou couches sacrificielles. Peut ainsi être cité le document US 5,919,305, où la couche sacrificielle, disposée à être partiellement ou totalement attaquée, peut être de l'oxyde de silicium, du nitrure de silicium, du carbure de silicium ou du silicium et où le principal objectif est de traiter le problème du désaccord de dilatation thermique responsable de la haute densité de défauts directement dans le réacteur d'épitaxie. Une autre technique a été mise au point et décrite dans le document EP 1 245 702, où le procédé vise à fournir des substrats de nitrure de gallium autosupportés en déposant entre le substrat et la couche épitaxiale de nitrure de gallium une couche de métal destinée à être éliminée par attaque chimique. Parmi les métaux adaptés à ce procédé l'aluminium, l'or, l'argent, le cuivre, le platine, le fer, le nickel, le titane, le zirconium, l'hafnium et leurs alliages sont cités.

Le document EP 1 246 233 décrit un procédé pour l'obtention d'un substrat autosupporté de nitrure d'élément III comprenant une étape de formation d'une couche de GaN sur un substrat de saphir, une étape de formation d'un fill de titane sur la couche de GaN et une couche de traitement thermique pour former des cavités dans la couche de GaN.

Le document WO96/41906 décrit un procédé de fabrication d'un article cristal simple de GaN comprenant une étape de fourniture d'un substrat ayant une surface compatible avec la croissance épitaxiale de GaN, une étape de dépôt d'une couche de cristal simple GaN sur la surface du substrat, une étape de retrait par gravure du substrat de la couche de cristal simple pour obtenir l'article de cristal simple.

L'ablation par radiation électromagnétique est une autre technique actuellement en développement dans le cadre de la recherche sur la fabrication de substrats de nitrure de gallium. Par exemple, l'ablation laser (LLO), qui est notamment décrite dans le brevet US 6,559,075, repose sur l'utilisation d'une émission laser UV pulsée qui traverse le saphir, mais qui est absorbée au niveau de la couche de GaN, provoquant une décomposition thermique locale du GaN proche de l'interface. D'autres documents utilisant cette technique peuvent être également cité parmi lesquels le document US2002/0182889 ou encore le document US 6,071,795.

En dernier lieu, le document WO03/062507 est relatif à un procédé de préparation d'un substrat autosupporté fait d'un matériau semi-conducteur par une technique de collage d'une couche de nucléation (par adhésion « moléculaire ») sur un substrat, préalablement à une étape d'épitaxie d'une couche monocristalline dudit matériau semi-conducteur. Cette couche de nucléation jouant le rôle d'interface spontanément détachable sous l'effet de la diminution de la température post-épitaxie, induisant des contraintes mécaniques au niveau de cette interface.

Au vu de ce qui précède, il ressort que les solutions proposées ne sont pas simples de conception. En effet, ces techniques ne mettent pas à l'abri notamment d'endommager la couche de nitrure d'élément III épitaxiée sur le substrat. Elles présentent souvent ainsi à la fois des inconvénients de mise en oeuvre et de coûts de production. Enfin, bien souvent, une fois la couche autosupportée séparée du substrat, elle présente une courbure non négligeable. Il en résulte que les substrats autosupportés issus des méthodes précitées ne sont pas suffisamment plan pour assurer l'uniformité des procédés qui peuvent être réalisés ultérieurement sur ces couches (épitaxie et/ou réalisation des composants électroniques avec par exemple des étapes de lithographie).

Ainsi, il existe un réel besoin de disposer de techniques alternatives de fabrication de substrats de nitrures d'éléments III plans sur de larges surfaces. L'objectif restant notamment l'homoépitaxie de nitrure de gallium conduisant à un matériau contenant une densité de défauts notablement moindre.

Le but de l'invention est de proposer un procédé de réalisation d'un substrat autosupporté de nitrure d'élément III, qui soit simple, rapide, peu coûteux et qui fournisse un film de nitrure d'élément III de bonne qualité, planaire et sur une large surface.

Ainsi, l'invention a pour objet un procédé de réalisation de substrats autosupportés de nitrure d'élément III et notamment de GaN à partir d'un substrat de départ, par dépôt de nitrure d'élément III par épitaxie, caractérisé en ce qu'il comporte l'utilisation, sur ledit substrat, d'une couche intermédiaire à base de silicium, à titre de couche sacrificielle destinée à être vaporisée spontanément lors de l'étape ultérieure d'épitaxie du nitrure d'élément III.

Le procédé selon l'invention est particulièrement adapté au nitrure de gallium à titre de nitrure d'élément III. Il est également possible de réaliser des substrats d'AlN, d'AlₓGa₁₋ₓN, d'InₓGa₁₋ₓN et plus généralement d'AlₓGa_{y}In_{1-x-y}N (avec 0≤x+y≤1) suivant le procédé de l'invention.

Le substrat massif de départ peut être n'importe quel matériau dont les propriétés chimiques et physiques sont compatibles avec l'épitaxie des nitrures d'éléments III et qui permet le dépôt d'une couche monocristalline de nitrure d'élément III. En d'autres termes, le substrat sur lequel est déposée la couche sacrificielle doit être de préférence stable (pas de décomposition trop rapide) aux conditions de croissance standard utilisées pour l'épitaxie des nitrures d'éléments III. On peut notamment citer au titre de substrat de départ le saphir (Al₂O₃) ou le carbure de silicium (SiC). La grande stabilité thermique et chimique du saphir ainsi que ses paramètres physiques (paramètre de maille et coefficient d'expansion thermique) étant des avantages importants pour l'épitaxie de nitrure de gallium, le saphir est préférentiellement utilisé comme substrat initial.

Le substrat de départ peut lui même être composé de différents matériaux.

D'autres substrats thermiquement et chimiquement stables peuvent encore être utilisés pour la mise en oeuvre du procédé selon l'invention, parmi lesquels il est possible de citer de façon non exhaustive, MgAl₂O₄, A1N, GaN, le quartz ou une combinaison de ces derniers.

La couche intermédiaire, dite sacrificielle, à base de silicium est avantageusement du silicium dopé ou non dopé. On entend par couche « à base de silicium » toute couche majoritairement constituée par du silicium. D'autres semiconducteurs à base de silicium présentant une bonne évaporation peuvent également être utilisés à ce titre. Le silicium présentant des impuretés parmi lesquelles l'aluminium, l'indium, le gallium, le phosphore ou encore le bore peut être mentionné. On peut encore citer le Si₁₋ₓGeₓ, avec de préférence une concentration molaire en germanium inférieure à x=10%.

L'épaisseur de la couche sacrificielle à base de silicium peut être comprise entre 100 nm et 10 µm.

La vaporisation spontanée de la couche intermédiaire sacrificielle lors de l'étape d'épitaxie de nitrure d'élément III présente l'avantage majeur de ne pas nécessiter d'étape de procédé supplémentaire spécifiquement dédiée à la séparation du substrat et de la couche épitaxiale de nitrure d'élément III. Autrement dit, la séparation est effectuée totalement ou en grande majorité *in situ,* dans le réacteur destiné à la croissance épitaxiale du nitrure d'élément III. Par ailleurs, comme il est explicité ci-après, un autre avantage afférent au procédé selon la présente invention est la réduction des contraintes sources de dislocations, mais aussi de la courbure du substrat de nitrure d'élément III ainsi obtenu, du fait de la présence de la couche intermédiaire à base de silicium qui a un caractère compliant et ductile.

Le nitrure d'élément III qui est déposé, peut être dopé ou non. A titre de substances dopantes, on peut notamment citer le magnésium, le zinc, le béryllium, le calcium, le carbone, le bore, le chrome, le silicium et le fer.

Selon un mode de réalisation préféré de l'invention, on choisira une couche de silicium monocristalline orientée suivant la direction <111> déposée sur le substrat. D'autres orientations du silicium peuvent toutefois être mises en oeuvre dans le cadre de la présente invention. Ainsi la couche monocristalline de silicium peut également être orientée selon les directions <110> et <100>. Les conditions de croissance favorables à ce type de dépôt sont généralement réalisées par épitaxie en phase vapeur (VPE). Les variantes de fabrication d'un tel dépôt, tel que le collage de la couche de silicium, et non son épitaxie, peuvent aussi être utilisées. Par exemple, une description des techniques de collage peut être trouvée dans l'article «Semiconductor wafer bonding », Sciences and Technology, Q.Y. Tong, U. Gosële, Wiley Interscience Publications. Cette remarque prévaut également pour l'obtention de couches Si orientées selon <110> ou <100>. L'épaisseur de la couche sacrificielle est avantageusement comprise entre 100 nm et 10 µm pour permettre une épitaxie optimale de la couche de nitrure d'élément III finale.

Selon une variante de l'invention, la couche intermédiaire à base de silicium peut être continue ou discontinue selon une géométrie particulière (i.e. de façon ordonnée) ou encore discontinue sans organisation particulière (i.e. discontinue désordonnée). Dans le cas où la couche sacrificielle n'est pas continue, le dépôt de nitrure d'élément III sur l'ensemble substrat/couche sacrificielle peut se faire soit à partir de la couche sacrificielle, soit à partir des zones du substrat massif non recouvertes par la couche sacrificielle, soit encore sur toute la surface du substrat non recouvert et de la couche sacrificielle.

L'utilisation d'une couche à base de silicium de haute qualité cristalline est préférable pour la croissance de nitrures d'éléments III de haute qualité.

La couche sacrificielle à base de silicium déposée sur saphir ou tout autre substrat compatible, comme précédemment cité, est utilisable comme substrat pour l'épitaxie de nitrures d'éléments III. Une étape de dépôt d'une couche de nucléation peut être réalisée avant de procéder à l'étape d'épitaxie de la couche épaisse de nitrure d'éléments III. La nature de cette couche de nucléation est choisie de telle sorte à :
- jouer le rôle de couche de protection momentanée pour la couche sacrificielle (les conditions de croissance habituelles des nitrures risquent d'être corrosives pour cette couche ; ceci est par exemple notoire dans le cas où la couche sacrificielle est du silicium),
- servir de site de germination à un nitrure d'élément III monocristallin : le paramètre de maille de la couche de nucléation doit être compatible avec le dépôt ultérieur de la couche de nitrure d'élément III qui constituera le futur substrat autosupporté.

En d'autres termes on utilise de préférence une couche de nucléation dont le paramètre de maille est approchant de celui du nitrure d'élément III de sorte à assurer un dépôt ultérieur de nitrure d'élément III monocristallin et à minimiser la formation de dislocations. Ainsi, à titre de couche de nucléation, il est possible de choisir parmi le groupe constitué par A1N, SiC, GaN basse température, AlGaN, AlₓGa_{y}In_{1-x-y}N (où 0≤x+y≤1), Al₂O₃, A1As, GaAs ou la combinaison de ces différentes couches.

La croissance de la couche de nucléation se fait de préférence par Epitaxie en Phase Vapeur d'OrganoMétalliques (EPVOM) à une vitesse de croissance comprise entre 0,01 et 3 µm/h. La température d'épitaxie est avantageusement inférieure à 1200°C pour ne pas endommager la couche de silicium lors de cette première étape. La technique dite épitaxie par jet moléculaire (EJM) peut être également utilisée.

Selon un mode de réalisation préféré de l'invention, le dépôt de la couche épaisse de nitrure d'élément III se fait en deux étapes : une étape initiale lente, juste après la couche de nucléation, est réalisée de sorte à conditionner une cristallinité optimale et une seconde étape de dépôt rapide qui permettra l'épaississement du matériau conduisant au futur substrat autosupporté de nitrure d'élément III.

La couche initiale est avantageusement déposée par EPVOM, à une vitesse pouvant être, de façon préférée, comprise entre 0,1 et 5 µm/h. La technique EJM peut être également utilisée.

Les épaisseurs de la couche de nucléation et de l'éventuelle couche de nitrure d'élément III initiale peuvent être comprises respectivement entre 0,01 et 0,5 µm et entre 0,1 et 10 µm.

La couche de nitrure d'élément III épitaxiée en seconde étape sur la couche initiale de nitrure d'élément III est réalisée par épitaxie en phase vapeur (VPE) jusqu'à obtenir une épaisseur finale suffisante pour que cette couche soit séparable du substrat de saphir sans se casser. De façon pratique cette étape d'épaississement est réalisée à grande vitesse (entre 10 et 200 µm/h généralement) et, pour se faire à bas coût, la technique appelée Epitaxie en Phase Vapeur aux Hydrures (HVPE) sera très avantageusement utilisée.

Typiquement, dans le cas de l'élaboration de substrats autosupportés de GaN, l'épitaxie est poursuivie jusqu'à ce que la couche de nitrure d'élément III atteigne au minimum 50 µm, épaisseur classiquement jugée suffisante pour que le substrat autosupporté soit « manipulable ». Dans le cadre de la présente invention, les substrats autosupportés de GaN ont typiquement une épaisseur variant de 300 µm à 1 mm dans le cas de substrats autosupportés de diamètre 2" un pouce (") est égale à 25.4 mm. L'épaisseur minimale est en fait celle pour laquelle le substrat est suffisamment solide pour être manipulé dans des conditions normales d'utilisation.

Lors de la croissance de la couche de nitrure d'élément III, les conditions de croissance (température, pression totale dans le réacteur, atmosphère, vitesse de croissance, ...) doivent permettre une vaporisation progressive de la couche intermédiaire à base de silicium déposée sur le substrat pour qu'ultimement la couche soit complètement ou majoritairement libérée ou pour ainsi dire décohérée du substrat initial. Ainsi, la vaporisation du semiconducteur à base de silicium doit être suffisamment lente pour ne pas perturber le déroulement de la croissance d'épaississement de la couche de nitrure d'élément III jusqu'à son terme. Pour cette raison, l'épaisseur de la couche intermédiaire nécessaire entre le substrat et la couche de nitrure d'élément III dépend des conditions de croissance utilisées pour l'épaississement de la couche de nitrure d'élément III. Il est à remarquer que la vaporisation d'une couche intermédiaire à base de silicium pourrait commencer à se produire lors de l'étape initiale de dépôt à faible vitesse du nitrure d'élément III, c'est à dire lors de l'étape EPVOM ou EJM, et se poursuivrait lors de l'étape d'épaississement en HVPE. Cette vaporisation risque d'être d'autant plus rapide que la température et/ou la pression des réacteurs seront grandes.

Les paramètres de croissance les plus adaptés à la croissance de la couche épaisse de nitrure d'élément III ainsi qu'à la séparation, pris séparément ou avantageusement en combinaison, sont les suivants :
- La pression est comprise entre 10² et 10⁵ Pa,
- La température est comprise entre 800°C et 1200°C,
- La vitesse de croissance est comprise entre 10 et 200 µm/h.

Comme précédemment cité, le procédé présente deux avantages. Le premier avantage est que le phénomène de vaporisation se produit en tout point identique sur de grandes surfaces. Le second avantage est que le matériau obtenu est considérablement peu contraint due à la dé-cohésion progressive du substrat au cours d'épaississement à haute température à mesure que la couche intermédiaire à base de silicium se vaporise. Cela conduit à l'obtention d'une couche finale de nitrure d'élément III quasi-planaire de courbure minimale.

Plus particulièrement, l'invention concerne un procédé de fabrication de substrat de nitrure d'élément III autosupporté monocristallin comportant les étapes successives suivantes :
(i) le dépôt ou le collage sur un substrat d'une couche sacrificielle à base de silicium,
(ii) le dépôt d'une couche de nucléation,
(iii) le dépôt par épitaxie d'une couche épaisse de nitrure d'élément III sur la bi-couche {couche intermédiaire à base de silicium / couche de nucléation}, dans des conditions opératoires compatibles avec une vaporisation spontanée de la couche sacrificielle à base de silicium.

D'autres caractéristiques, buts et avantages de l'invention apparaîtront à la lecture de la description détaillée qui va suivre du mode particulier de réalisation de l'invention dans le cas de l'obtention d'un substrat autosupporté de nitrure de gallium où la couche sacrificielle est du silicium, mettant en oeuvre les étapes successives (i) à (iii) décrites ci-dessus, en référence aux figures sur lesquelles :

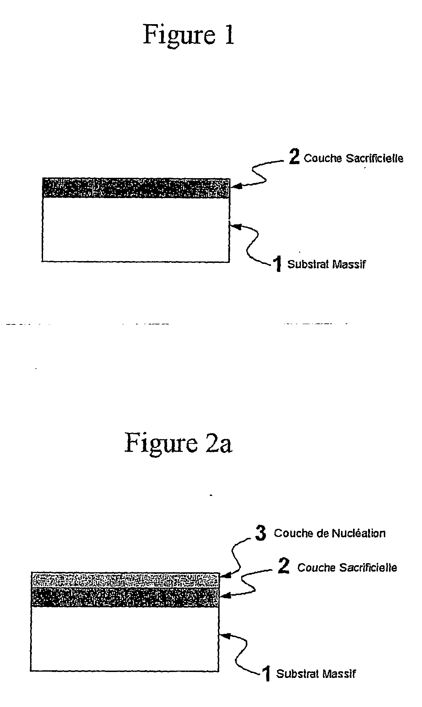

- la figure 1 est une représentation du substrat de départ 1 muni d'une couche sacrificielle 2 à base de silicium suite à une étape de dépôt ou à un collage (i),
- la figure 2a est une représentation du substrat 1 muni d'une couche sacrificielle 2 à base de silicium couvrant entièrement le substrat 1, sur laquelle est déposée une couche de nucléation 3,

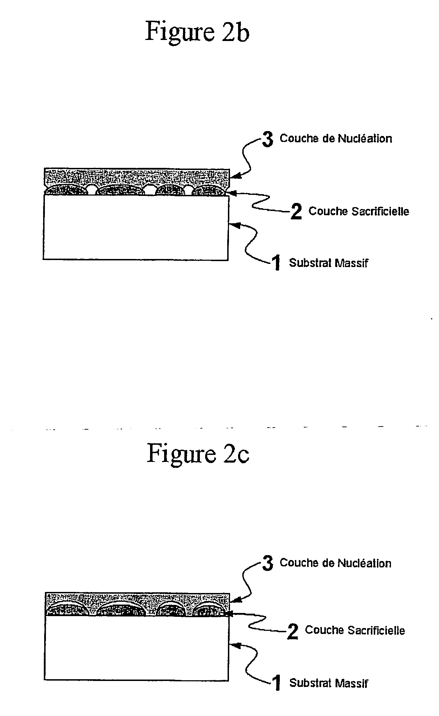

- la figure 2b est une représentation du substrat 1 muni successivement d'une couche sacrificielle 2 à base de silicium ne couvrant pas entièrement le substrat 1 et d'une couche de nucléation 3 qui est épitaxiée uniquement sur la couche discontinue 2,
- la figure 2c est une représentation du substrat 1 muni successivement d'une couche sacrificielle 2 à base de silicium ne couvrant pas entièrement le substrat 1 et d'une couche de nucléation 3 qui est épitaxiée uniquement sur le substrat massif 1 à partir des zones non couvertes par la couche sacrificielle 2,

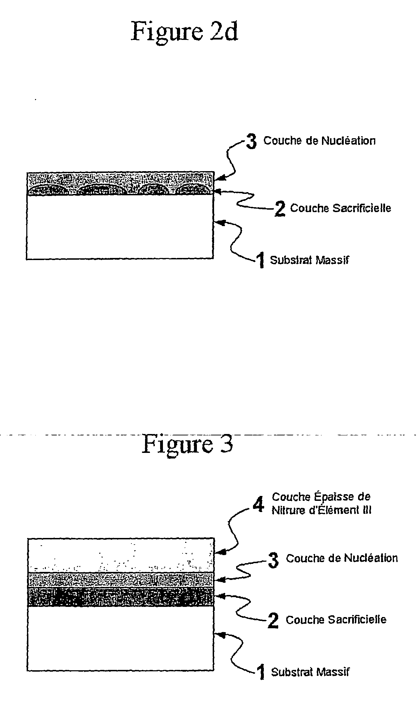

- la figure 2d est une représentation du substrat 1 muni successivement d'une couche sacrificielle 2 à base de silicium ne couvrant pas entièrement le substrat 1 et d'une couche de nucléation 3 qui est épitaxiée sur la couche sacrificielle 2 ainsi que sur les parties non recouvertes du substrat 1,
- la figure 3 est une représentation du substrat 1 muni successivement d'une couche sacrificielle 2 à base de silicium, d'une couche de nucléation 3 et d'une couche 4 de nitrure d'élément III, suite à l'étape (ii) et en cours de l'étape (iii),

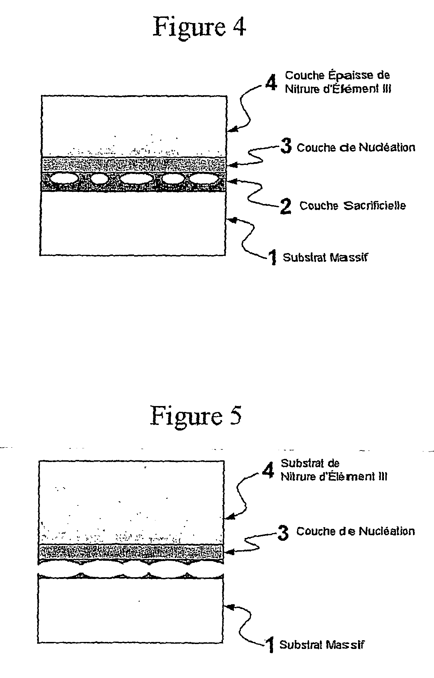

- la figure 4 est une représentation du substrat 1 muni des mêmes couches que celles représentées à la figure 3, où la couche de silicium 2 est en cours de vaporisation,
- la figure 5 est une représentation du substrat en fin de procédé, où la couche sacrificielle 2 est quasiment totalement vaporisée. Cette figure montre le résultat du procédé : à savoir d'une part une couche épaisse autosupportée plate et de grande surface (avec d'éventuel résidus de la couche sacrificielle en face arrière) et d'autre part le substrat 1 de départ, potentiellement recouvert de résidus mais recyclable.
- la figure 6 est une illustration du phénomène de vaporisation de la surface d'un substrat massif de silicium lors de la croissance d'une couche de GaN par EPVOM par dessus, décrite à l'exemple 1.
Il est à noter que les schémas ne sont pas représentés à l'échelle.

Les modes de réalisation préférés de l'invention vont être décrits dans ce qui suit. En particulier, des descriptions plus détaillées de ce que sont les couches 1, 2, 3 et 4 sont reprises et développées.

Le substrat massif 1 doit permettre le dépôt d'une couche sacrificielle monocristalline. Cela implique que le substrat massif 1 doit être de préférence monocristallin dans le cas ou la couche sacrificielle 2 est épitaxiée sur le substrat 1. On peut ainsi proposer par exemple les substrats massifs monocristallins suivants : Al₂O₃, SiC, AlN, GaN.

Le substrat massif 1 est avantageusement le saphir (Al₂O₃) ou le carbure de silicium (SiC) car ils possèdent des coefficients d'expansion thermique proche des nitrures d'éléments III et sont stables chimiquement.

L'épaisseur optimale du substrat massif 1 est celle de substrat standard : elle est comprise entre 150 µm et 1000 µm pour un substrat de diamètre 2". De façon préférentielle elle peut être comprise entre 300 µm et 500 µm.

L'orientation cristalline du substrat massif 1 est de préférence C(0001) ou R(10-12) légèrement désorienté (de quelques degrés) ou non. On peut également citer les orientations A(11-20) et M(1-100).

Il est préférable que la couche intermédiaire 2 qui sert de couche sacrificielle soit une couche de silicium. Lorsque la couche sacrificielle 2 est du silicium, l'épitaxie sur saphir (0001) donne un cristal de silicium (111) dont la surface présente un arrangement atomique hexagonal, adapté à l'épitaxie de nitrure d'élément III orienté selon (0001).

Il est préférable que la couche sacrificielle 2 soit monocristalline avec la meilleure qualité structurale possible. Sa structure cristalline doit approcher celle du matériau massif de préférence.

De manière à faciliter la croissance d'un substrat de nitrure d'éléments III orienté suivant la direction cristallographique (0001), il est préférable d'utiliser une couche sacrificielle 2 dont la face d'épitaxie présente une symétrie hexagonale, comme par exemple un cristal orienté suivant la direction <111>. En second choix, après l'utilisation d'une couche sacrificielle 2 orientée suivant la direction <111>, peuvent être utilisées des couches orientées suivant les directions <100> ou <110>. En effet, il est entre autre possible d'épitaxier les nitrures d'éléments III avec une structure hexagonale sur de telles couches sacrificielles, malgré l'absence de symétrie hexagonale de la couche servant de substrat.

Une variante préférée de l'invention consiste à utiliser une couche sacrificielle 2 de silicium orientée suivant la direction <111> collée à un substrat 1, et non pas épitaxiée. Dans ce cas, le substrat 1 n'a pas besoin d'être monocristallin, contrairement à la couche sacrificielle 2 qui est de préférence monocristalline. On peut ainsi proposer par exemple les substrats massifs 1 monocristallins ou polycristallins suivants : AlN, GaN, Al₂O₃, SiC, quartz.

L'épaisseur de la couche intermédiaire sacrificielle 2 est comprise de préférence entre 0,1 et 5 µm. L'épaisseur optimale dépend des conditions de croissance utilisées pour l'épitaxie du futur substrat 4 de nitrure d'élément III. Plus la température de croissance est élevée et plus l'épaisseur de la couche sacrificielle doit être grande pour éviter une séparation trop rapide de la couche en croissance 4 et du substrat 1. De même, il sera avantageux d'augmenter l'épaisseur de la couche sacrificielle 2 pour une pression de croissance élevée.

Il est préférable d'utiliser une couche de nucléation 3, déposée sur la couche sacrificielle 2, pour permettre un meilleur dépôt de la couche épaisse 4 de nitrure d'élément III qui deviendra le substrat autosupporté.

Il est préférable d'utiliser une couche de nitrure d'aluminium (AlN) comme couche de nucléation 3. L'épaisseur de la couche de nucléation 3 est de préférence comprise ente 10 nm et 50 nm.

La croissance de la couche de nucléation se fait de préférence par EPVOM à une vitesse de croissance comprise entre 0,1 et 3 µm/h. La température d'épitaxie est avantageusement comprise entre 900°C et 1100°C et la pression inférieure à 5x10⁴ Pa pour ne pas évaporer trop rapidement la couche 2 de silicium tout en conservant une qualité cristalline élevée des couches épitaxiées.

Tout en restant dans le cadre de l'invention, il est aussi possible d'utiliser l'épitaxie par jet moléculaire (EJM) pour déposer la couche de nucléation 3. Les étapes réalisées par EPVOM dans le procédé peuvent aussi être réalisées par EJM. Les conditions de croissance sont alors très différentes (typiquement très basse pression P=10⁻⁴ à 10⁻⁷ Torr et faible température T=700°C).

Si la couche sacrificielle 2 n'est pas continue (organisée ou non), une variante de l'invention consiste à déposer la couche de nucléation 3 :
- Soit exclusivement sur la couche sacrificielle 2. Dans ce cas la couche de nucléation n'est pas continue et une couche de nitrure d'élément III plane est obtenue dans la dernière étape d'épaississement par HVPE,
- Soit exclusivement sur les parties du substrat 1 non recouvertes par la couche sacrificielle. Il n'y a alors aucun lien cristallographique entre la couche sacrificielle 2 et la couche de nucléation 3. Dans ce cas la relation épitaxiale entre le substrat et la couche de nucléation peuvent être mis à profit pour augmenter la qualité cristalline de la couche de nucléation 3, sans remettre en cause la séparation de la couche de nitrure d'élément III du substrat de départ 1 lors de la vaporisation de la couche sacrificielle 2.
- Soit sur toute la surface de la couche sacrificielle 2 et des parties nues du substrat 1.

Il est préférable d'améliorer le plus possible la qualité cristalline de la couche servant de substrat pour l'épitaxie de la couche épaisse 4 de nitrure d'élément III qui deviendra le substrat autosupporté. Ainsi il est préférable de déposer une couche de nitrure d'élément III par EPVOM ou EJM à faible vitesse précédant l'épitaxie de la couche épaisse 4 de nitrure d'élément III. De plus, il est préférable d'utiliser les techniques de croissance connues de l'homme du métier visant à diminuer les densités de défauts présents dans la couche de nucléation. On peut citer par exemple la technique ELO (pour Epitaxial Lateral Overgrowth) décrite dans l'article de revue « Epitaxial Lateral Overgrowth of GaN », B. Beaumont, P. Vennéguès, P. Gibart, phys. stat. sol. (b) 227, No. 1, 1-43 (2001), la technique d'ELO sans masque décrite dans l'article « Growth of high-quality GaN by low-pressure metal-organic vapour phase epitaxy (LP-MOVPE) from 3D islands and lateral overgrowth », H. Lahrèche, P. Vennéguès, B. Beaumont and P. Gibart, Journal of Crystal Growth 205, 245 (1999), ou encore la technique de formation d'îlots de GaN, dite « micro-ELO spontanée », décrite dans MRS Internet J. Nitride Semicond. Res. 7, 8 (2002) permettant d'éliminer l'étape de gravure d'un masque de diélectrique grâce à la formation spontanée de motifs de GaN, sous forme d'îlots, jouant le même rôle.

Ces techniques sont connues pour leur capacité à réduire la densité de défauts étendus de façon drastique, fournissant de ce fait un matériau de nitrure de gallium de qualité supérieure. Toutefois, cette étape n'est pas obligatoire (notamment parce que nécessitant une étape de technologie supplémentaire et donc pouvant être coûteuse).

Les conditions préférées utilisées pour la dernière étape du procédé de fabrication de substrat de nitrure d'élément III et qui concerne le dépôt d'une couche épaisse 4 de nitrure d'élément III et sa séparation du substrat de départ par évaporation de la couche sacrificielle sont développés ici.
Lorsque l'on désire fabriquer des couches épaisses 4 de nitrure d'élément III, la technique de croissance la mieux adaptée est l'épitaxie en phase vapeur aux hydrures (HVPE) car elle permet des vitesses de croissance pouvant dépasser 100 um/h (très supérieure à la moyenne de 3 µm/h recommandable en EPVOM) sans perte de qualité cristalline. En terme de qualité cristalline, une épitaxie de GaN par HVPE à partir d'une couche de départ de GaN épitaxiée par MOVPE sur saphir (sans aucune étape de type ELO) conduit à une couche présentant une densité de dislocation qui diminue avec l'épaisseur h déposée selon une loi en puissance h^{-2/3} (voir article de S.K. Mathis, Jnl. Cryst. G. 231, 371 (2001))du fait du croisement et de l'annihilation des dislocations. Typiquement, une couche épaisse de 300 µm présente une densité de dislocation en moyenne de 10⁷ cm⁻² et une couche épaisse de 1000 µm présente une densité de dislocation moyenne de 4x10⁶cm⁻². Une étape ELO permet d'éventuellement réduire davantage la densité de dislocation (d'au moins un facteur 10).

La vaporisation, partielle ou totale, de la couche sacrificielle 2 se produit lors de l'épitaxie de la couche épaisse 4 de nitrure d'élément III qui deviendra par la suite le substrat. Les conditions de croissance optimales pour les nitrures d'éléments III par VPE sont compatibles avec la vaporisation spontanée du silicium.

Il est préférable de ne pas évaporer trop rapidement la couche sacrificielle 2 de façon à ne pas perturber la croissance du nitrure d'élément III et de ne pas séparer trop rapidement la couche en croissance du substrat pour ne pas casser la couche de nitrure d'élément III.

En particulier, une température comprise entre 900°C et 1100°C et une pression comprise entre 10² Pa et 10⁵ Pa permettent une croissance optimale de la couche 4 de nitrures d'éléments III et une vitesse de vaporisation optimale pour une couche sacrificielle 2 de silicium.

Dans le cas où la couche sacrificielle 2 à base de silicium n'est pas entièrement évaporée après l'étape d'épitaxie du nitrure d'élément III, laissant subsister un résidu de la couche sacrificielle sur le substrat de nitrure d'élément III, une étape supplémentaire d'attaque chimique de la couche 2 à base de silicium peut s'avérer utile pour éliminer entièrement ce silicium du substrat de nitrure d'élément III. L'attaque chimique peut se faire selon des techniques connues par l'état de l'art. Elle est de préférence réalisée à basse température lorsque le matériau obtenu est déchargé du réacteur d'épitaxie. La solution chimique dépend du type de couche intermédiaire : pour du silicium, on utilise généralement le mélange HNO₃:HF ou le KOH.

Les couches de GaN autosupportées obtenues selon le procédé de l'invention présentent un grand intérêt pour la fabrication de composants électroniques ou optoélectroniques tels que des diodes laser, des diodes électroluminescentes, des photodétecteurs, des transistors etc... Ceci est notamment vrai grâce à la spécificité du procédé qui permet de minimiser considérablement les contraintes dans le matériau habituellement créées pendant l'épitaxie et le refroidissement, et par la suite de minimiser la courbure du substrat de nitrure d'élément III obtenu, typiquement pour atteindre un rayon de courbure supérieur à 5 m. En particulier le rayon de courbure peut avoisiner ou dépasser 10 m.

Un autre avantage du procédé selon l'invention est que le substrat de départ peut être réutilisé plusieurs fois après séparation de la couche de GaN, un repolissage pouvant s'avérer nécessaire après chaque utilisation.

L'invention a également pour objet un substrat autosupporté de nitrure d'élément III susceptible d'être obtenu selon le procédé de l'invention, caractérisée en ce que son diamètre est supérieur ou égal à 2" et en ce qu'il possède un rayon de courbure supérieur à 5 m.

Dans un aspect avantageux, le substrat autosupporté de nitrure d'élément III susceptible d'être obtenu selon le procédé de l'invention a un diamètre supérieur ou égal à 2" et possède un rayon de courbure supérieur ou égal à 10m.

### Les exemples décrits ci-après illustrent l'invention.

### Exemple 1 : Procédé par MOCVD/HVPE sur saphir C.

Un substrat autosupporté de nitrure de gallium est réalisé selon le procédé de l'invention. Le substrat de départ consiste en une couche de silicium de 2 µm orientée suivant la direction (111) épitaxié par CVD sur un substrat de saphir (Al₂O₃) orienté suivant (0001) de 430 µm d'épaisseur et de diamètre 2". La largeur à mi-hauteur en balayage ω/2*θ* par diffraction de rayons X de la couche de silicium est de l'ordre de 400 arcsec.
La première étape de croissance de nitrure de gallium est faite par EPVOM. Les conditions de croissance sont les suivantes :
- Température T=1090°C
- Pression P=10⁴ Pa
- Vitesse de croissance de la couche de nucléation AlN V_{AlN}=0.2 µm/h,
- Vitesse de croissance de la couche initiale de GaN V_{GaN}=1.5-3 µm/h
- Rapport V/III pour GaN = 5000
- Composition gazeuse dans le réacteur de croissance H₂:N₂ =1:1

La couche de nucléation d'AlN est déposée à haute température après un recuit/désoxydation de la couche de silicium sous flux H₂:N₂ pendant 5 min. L'épaisseur de la couche d'AlN est 30 nm.

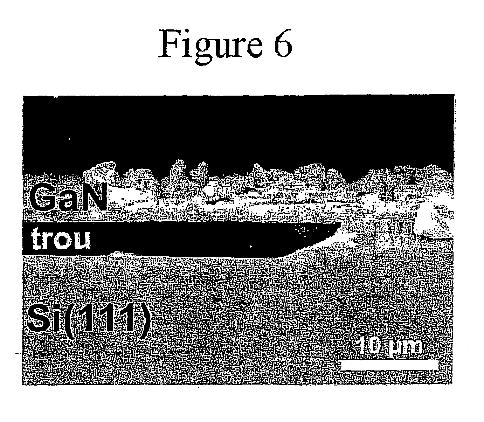

La première couche de GaN est déposée sur la couche de nucléation à basse vitesse de croissance (1,5 µm/h). L'épaisseur de cette couche est d'environ 1 µm. La largeur à mi-hauteur en balayage ω/2*θ* par diffraction de rayons X de la couche de GaN est environ 1000 arcsec. La qualité cristalline augmente avec l'épaisseur déposée (les dislocations se croisent et s'annihilent), mais le silicium commence déjà à s'évaporer et/ou à diffuser dans la couche en croissance (il diffusera probablement moins si T∼1040°C). La figure 6 illustre la vaporisation de silicium dans le cas pratique du dépôt par EPVOM de GaN/AlN sur un substrat massif de Si(111). Le trou entre le substrat et la couche de GaN est dû à l'évaporation de silicium pendant l'épitaxie. Dans ce cas l'évaporation rapide perturbe la croissance de GaN. De tels trous apparaissent sur toute la surface du substrat et pas uniquement à partir des bords du substrat.

Il convient donc de ne pas épitaxier une couche trop épaisse en EPVOM pour ne pas consommer tout le silicium avant l'étape finale d'épaississement à plus haute vitesse par HVPE.

L'épaississement de GaN est réalisé par HVPE en utilisant les conditions de croissance suivantes :
- Température T=1000°C
- Pression P=2x10⁴ Pa
- Vitesse de croissance V_{GaN}=100 µm/h
- Composition gazeuse H₂:N₂:NH3:HCl

L'épaisseur déposée par HVPE est de 500 µm. Plus l'épaisseur est élevée et plus la qualité cristalline du matériau déposée augmente, toujours via un processus d'élimination progressive des dislocations qui se croisent et s'annihilent. La densité de dislocations typique mesurée est de 5x10⁶ cm⁻², ce qui correspond à la valeur attendue suite à un épaississement de 500 µm par HVPE. Cette densité de dislocations est donc équivalente à celle obtenue pour d'autres techniques de fabrication de substrat de GaN autosupporté (exemple : séparation par ablation laser).

La séparation de la couche épaisse de GaN et du substrat de saphir est constatée après croissance HVPE sur toute la surface (2"). Seules quelques traces de silicium subsistent sur la face arrière de la couche de nitrure autosupportée ; ces traces peuvent être éliminées par attaque chimique.

La largeur à mi-hauteur en balayage ω/2θ par diffraction de rayons X pour le substrat de GaN obtenu est inférieure à 100 arcsec. La largeur à mi-hauteur des raies excitoniques (D⁰X,A, C) observées par photoluminescence sont inférieures à 1 meV.

### Exemple 2 : procédé par EJM/HVPE sur saphir C.

Un substrat autosupporté de nitrure de gallium est réalisé selon le procédé de l'invention. Le substrat de départ consiste en une couche de silicium de 5 µm orientée suivant la direction (111) épitaxié par CVD sur un substrat de saphir (Al₂O₃) orienté suivant (0001) de 430 µm d'épaisseur et de diamètre 2".
La première étape de croissance de nitrure de gallium est faite par EJM. Les conditions de croissance sont les suivantes :
- Température T=800°C
- Pression P=10⁻⁵ Torr
- Vitesse de croissance de la couche de nucléation AlN V_{AlN}=0,2µm/h,
- Vitesse de croissance de la couche initiale de GaN V_{GaN}=1 µm/h
- Rapport V/III pour GaN = 10

La couche de nucléation d'AlN est déposée à haute température après un recuit/désoxydation de la couche de silicium sous vide à haute température (850°C). L'épaisseur de la couche d'AlN est 30 nm.

La première couche de GaN est déposée sur la couche de nucléation à basse vitesse de croissance (1µm/h). L'épaisseur de cette couche est d'environ 500 nm. La qualité cristalline augmente avec l'épaisseur déposée (les dislocations se croisent et s'annihilent).

L'épaississement de GaN est réalisé par HVPE en utilisant les conditions de croissance suivantes :
- Température T=950-1000°C.
- Pression P=10⁴ Pa
- Vitesse de croissance V_{GaN}=100 µm/h
- Composition gazeuse H₂:N₂:NH3:HCl

L'épaisseur déposée par HVPE est 1000 µm. Plus l'épaisseur est élevée et plus la qualité cristalline du matériau déposée augmente, toujours via un processus d'élimination progressive des dislocations qui se croisent et s'annihilent.

La séparation de la couche épaisse de GaN et du substrat de saphir est constatée après croissance HVPE sur toute la surface (2").. Seules quelques traces de silicium subsistent sur la face arrière de la couche de nitrure autosupportée ; ces traces peuvent être éliminées par attaque chimique.

### Exemple 3 : procédé sur substrat SiC.

Un substrat autosupporté de nitrure de gallium est réalisé selon le procédé de l'invention. Le substrat de départ consiste en une couche de silicium de 0.5 µm orientée suivant la direction (111) épitaxié par CVD sur un substrat de carbure de silicium de type 6H-SiC, orienté suivant (0001), d'une épaisseur de 280 µm et de diamètre 2".

La première étape de croissance de nitrure de gallium est faite par EPVOM. Les conditions de croissance sont les suivantes :
- Température T = 1090°C
- Pression P = 2x10⁴ Pa
- Vitesse de croissance de la couche de nucléation AlN V_{AlN} = 0.1 µm/h,
- Vitesse de croissance de la couche initiale de GaN V_{GaN}=1.5 µm/h
- Rapport V/III pour GaN = 2000
- Composition gazeuse du réacteur de croissance H₂:N₂=1:0

La couche de nucléation d'AlN est déposée à haute température après un recuit/désoxydation de la couche de silicium sous flux H₂ pendant 10 min. L'épaisseur de la couche d'AlN est 50 nm.

La première couche de GaN est déposée sur la couche de nucléation à basse vitesse de croissance (1,5 µm/h). L'épaisseur de cette couche est d'environ 1 µm.

L'épaississement de GaN est réalisé par HVPE en utilisant les conditions de croissance suivantes :
- Température T = 950-1000°C
- Pression P=10⁴Pa
- Vitesse de croissance V_{GaN}= 150 µm/h
- Composition gazeuse H₂:N₂:NH3:HCl

L'épaisseur déposée par HVPE est 1000 µm. La séparation de la couche épaisse de GaN et du substrat de saphir est constatée après croissance HVPE sur toute la surface (2"). Seules quelques traces de silicium subsistent sur la face arrière de la couche de nitrure autosupportée ; ces traces peuvent être éliminées par attaque chimique..

### Exemple 4 : procédé sur substrat Saphir-plan R

Un substrat autosupporté de nitrure de gallium est réalisé selon le procédé de l'invention. Le substrat de départ consiste en une couche de silicium de 2 µm orientée suivant la direction (100) épitaxié par CVD sur un substrat de saphir (Al₂O₃) orienté suivant (10-12) de 430 µm d'épaisseur et de diamètre 2".

La première étape de croissance de nitrure de gallium est faite par EPVOM sur une couche intermédiaire d'A1N. Les conditions de croissance sont les suivantes :
- Température T=1090°C
- Pression P=10⁴ Pa
- Vitesse de croissance de la couche de nucléation AlN V_{AlN}=0.2 µm/h,
- Vitesse de croissance de la couche initiale de GaN V_{GaN}=1,5 um/h
- Rapport V/III pour GaN =3000
- Composition gazeuse du réacteur H₂:N₂ =1:1

La couche de nucléation d'AlN est déposée à haute température après un recuit/désoxydation de la couche de silicium sous flux N₂ pendant 5 min. L'épaisseur de la couche d'AlN est 100 nm.

La première couche de GaN est déposée sur la couche de nucléation à basse vitesse de croissance (1,5 µm/h). L'épaisseur de cette couche est d'environ 200 nm. Elle peut avoir une structure cristalline hexagonale ou cubique suivant les paramètres de croissance. Dans cet exemple, la croissance de nitrure de gallium hexagonal est favorisée.

L'épaississement de GaN est réalisé par HVPE en utilisant les conditions de croissance suivantes :
- Température T=980°C
- Pression P=10⁴ Pa
- Vitesse de croissance V_{GaN}=100 µm/h
- Composition gazeuse H₂:N₂:NH3:HCl

L'épaisseur déposée par HVPE est 500 µm. La séparation de la couche épaisse de GaN et du substrat de saphir est constatée après croissance HVPE sur toute la surface (2"). Seules quelques traces de silicium subsistent sur la face arrière de la couche de nitrure autosupportée ; ces traces peuvent être éliminées par attaque chimique.

### Exemple 5 : emploi ELO (bandes) à partir d'une couche AlN

Un substrat autosupporté de nitrure de gallium est réalisé selon le procédé de l'invention. Le substrat de départ consiste en l'empilement suivant : une couche de silicium de 1 µm orientée suivant la direction (111) épitaxié par CVD sur une couche de d'AlN de 50 nm déposée sur une couche de GaN de 2 µm sur un substrat de saphir (Al₂O₃) orienté suivant (0001) de 430 µm d'épaisseur et de diamètre 2". La couche d'AlN sert de barrière protectrice entre la couche de silicium et la couche de GaN qui peuvent réagir ensemble et se dégrader (diffusion du silicium dans GaN).

Une couche de SiO₂ de 200 nm qui va servir de masque est déposée sur la couche de silicium. Des motifs formés de bandes de quelques microns de larges séparées par plusieurs microns (typiquement 5 µm/5 µm) sont révélés dans la couche de SiO₂ par une étape de photolithographie standard et une attaque chimique par BOE durant 3 min. Ensuite une attaque chimique de la couche de silicium par KOH à 80°C pendant 10 min est utilisée pour graver la couche de silicium non masquée jusqu'à la couche d'AlN (avec le même motif que celui définit par photolithographie).

Une première étape de recroissance de nitrure de gallium est faite par EPVOM aux ouvertures de la couche de silicium à partir de la couche d'AlN. Le dépôt de GaN est fait pour obtenir une couche continue et de préférence plane avant la croissance par HVPE en utilisant une technique de croissance bien connue appelée ELO. L'épaisseur de GaN déposée est 2 µm. Les conditions de croissance sont les suivantes :
- Température T = 1120°C
- Pression P = 1x10³ Pa
- Vitesse de croissance de la couche initiale de GaN V_{GaN} 2 µm/h
- Rapport V/ III pour GaN = 5000
- Composition gazeuse du réacteur H₂:N₂ = 1:1

Cette étape de recroissance ELO permet une réduction de la densité de dislocations de 1 à 2 ordres de grandeur dans la couche de GaN déposée dans la première étape.
L'épaississement de GaN est réalisé par HVPE en utilisant les conditions de croissance suivantes:
- Température T = 950-1000°C
- Pression P = 10⁴ Pa
- Vitesse de croissance V_{GaN} = 100 µm/h
- Composition gazeuse H₂:N₂:NH3:HCl

L'épaisseur déposée par HVPE est 500 µm. La séparation de la couche épaisse de GaN et du substrat de saphir est constatée après croissance HVPE sur toute la surface (2"). Seules quelques traces de silicium subsistent sur la face arrière de la couche de nitrure autosupportée ; ces traces peuvent être éliminées par attaque chimique.

La densité de dislocations mesurée est inférieure à 5x10⁶ cm⁻² grâce à l'utilisation de la technique ELO.

### Exemple 6 : emploi ELO (trous) à partir d'une couche GaN

Un substrat autosupporté de nitrure de gallium est réalisé selon le procédé de l'invention. Le substrat de départ consiste en l'empilement suivant : une couche de silicium de 1 µm orientée suivant la direction (111) épitaxié par CVD sur une couche de d'A1N de 50 nm déposée sur une couche de GaN de 2 µm sur un substrat de saphir (Al₂O₃) orienté suivant (0001) de 430 µm d'épaisseur et de diamètre 2".

Une couche de SiN de 20 nm qui va servir de masque est déposée sur la couche de silicium. Des motifs formés de trous de quelques microns de diamètre, séparées par plusieurs microns (typiquement 5 µm/15 µm), sont révélés dans la couche de SiN par une étape de photolithographie standard et une attaque par plasma (RIE) utilisant par exemple les gaz Cl₂ ou O₂. Ensuite une attaque chimique de la couche de silicium par KOH à 80°C pendant 10 min. est utilisée pour graver la couche de silicium jusqu'à la couche d'AlN avec le même motif que celui définit par photolithographie. Enfin la couche d'Al̅N est gravée jusqu'à la couche de GaN par RIE (plasma Cl₂).

Une première étape de recroissance de nitrure de gallium est faite par EPVOM aux ouvertures de la couche de silicium à partir de la couche de GaN. Le dépôt de GaN est fait pour obtenir une couche continue et de préférence plane avant la croissance par HVPE en utilisant une technique de croissance bien connue appelée ELO. L'épaisseur de GaN déposée est 2 µm. Les conditions de croissance sont les suivantes :
- Température T = 1090°C
- Pression P = 10⁴ Pa
- Vitesse de croissance de la couche initiale de GaN V_{GaN} =3 µm/h
- Rapport V/III = 5000
- Composition gazeuse du réacteur H₂:N₂=1:1

L'épaississement de GaN est réalisé par HVPE en utilisant les conditions de croissance suivantes :
- Température T=950-1000°C
- Pression P=10⁴ Pa
- Vitesse de croissance V_{GaN} =150 µm/h
- Composition gazeuse H₂:N₂:NH3:HCl

L'épaisseur déposée par HVPE est 500 µm. La séparation de la couche épaisse de GaN et du substrat de saphir est constatée après croissance HVPE. Seules quelques traces de silicium subsistent sur la face arrière de la couche de nitrure autosupportée ; ces traces peuvent être éliminées par attaque chimique.

### Exemple 7 : emploi ELO à partir du saphir

Un substrat autosupporté de nitrure de gallium est réalisé selon le procédé de l'invention. Le substrat de départ consiste en une couche de silicium de 1 µm épitaxié par CVD sur un substrat de saphir (Al₂O₃) orienté suivant (0001) de 430 µm d'épaisseur et de diamètre 2".

Une couche de SiO₂ de 200 nm qui va servir de masque est déposée sur la couche de silicium. Des motifs formés de bandes de quelques microns de larges séparées par plusieurs microns (typiquement 5µm/5µm) sont révélés dans la couche de SiO₂ par une étape de photolithographie standard et une attaque chimique par BOE durant 3 min. Ensuite une attaque chimique de la couche de silicium par KOH à 80°C pendant 10 min est utilisée pour graver la couche de silicium jusqu'au substrat de saphir avec le même motif que celui définit par photolithographie.

Une première étape de croissance de nitrure de gallium est faite par EPVOM aux ouvertures de la couche de silicium à partir du substrat de saphir à basse température (600°C) pour obtenir un dépôt homogène sur toute la surface. L'épaisseur de cette couche de GaN est d'environ 30 nm. Ensuite un recuit est fait à température de croissance standard (1090°C) pendant 10 min pour transporter le dépôt de GaN polycristallin qui a été déposé sur le masque de SiO₂ et le recristalliser sur le GaN déposé sur les ouvertures du masque de SiO₂ et du silicium qui lui est parfaitement orienté par rapport au substrat.
Un dépôt de GaN de 2 µm d'épaisseur suit l'étape de recristallisation. Les conditions de croissance sont les suivantes : température T =1100°C
- Pression P = 2x10⁴ Pa
- Vitesse de croissance de la couche initiale de GaN V_{GaN} = 3 µm/h
- Rapport V/ III pour GaN= 2000
- Composition gazeuse du réacteur H₂:N₂=1:1

L'épaississement de GaN est réalisé par HVPE en utilisant les conditions de croissance suivantes :
- Température T = 950-1000°C
- Pression P=10⁴ Pa
- Vitesse de croissance V_{GaN}= 100 µm/h
- Composition gazeuse H₂:N₂:HCl

L'épaisseur déposée par HVPE est comprise entre 300 et 1000 µm. La séparation de la couche épaisse de GaN et du substrat de saphir est constatée après croissance HVPE. Seules quelques traces de silicium subsistent sur la face arrière de la couche de nitrure autosupportée ; ces traces peuvent être éliminées par attaque chimique.

### Exemple 8 : emploi ELO (bandes) et substrat Saphir plan R

Un substrat autosupporté de nitrure de gallium est réalisé selon le procédé de l'invention. Le substrat de départ consiste en l'empilement suivant : une couche de silicium de 1 µm déposée sur une couche d'AlN de 50 nm déposée sur une couche de GaN orientée suivant la direction A(11-20) de 2 µm sur un substrat de saphir (Al₂O₃) orienté suivant la direction R(10-12) de 430 µm d'épaisseur et de diamètre 2". La couche d'AlN sert de barrière protectrice entre la couche de silicium et la couche de GaN qui peuvent réagir ensemble et se dégrader (diffusion du silicium dans GaN).

Une couche de SiO₂ de 200 nm qui va servir de masque est déposée sur la couche de silicium. Des motifs formés de bandes de quelques microns de larges séparées par plusieurs microns (typiquement 5 µm/5 µm) sont révélés dans la couche de SiO₂ par une étape de photolithographie standard et une attaque chimique par BOE durant 3 min. Ensuite une attaque chimique de la couche de silicium par KOH à 80°C pendant 10 min est utilisée pour graver la couche de silicium non masquée jusqu'à la couche d'AlN (avec le même motif que celui définit par photolithographie).

Une première étape de recroissance de nitrure de gallium est faite par EPVOM aux ouvertures de la couche de silicium à partir de la couche d'AlN. Le dépôt de GaN est fait pour obtenir une couche continue avant la croissance par HVPE en utilisant la de croissance ELO. L'épaisseur de GaN déposée est 2 µm. Les conditions de croissance sont les suivantes :
- Température T =1120°C
- Pression P=2x10³ Pa
- Vitesse de croissance de la couche initiale de GaN V_{GaN} = 2µm/h
- Rapport V/ III pour GaN = 5000
- Composition gazeuse du réacteur H₂:N₂ = 1:1

Cette étape de recroissance ELO permet une réduction de la densité de dislocations et de défauts étendus d'au moins un ordre de grandeur dans la couche de GaN.

L'épaississement de GaNest réalisée par HVPE en utilisant les conditions de croissance suivantes :
- Température T = 950-1000°C
- Pression P=10⁴ Pa
- Vitesse de croissance V_{GaN}= 100 µm/h
- Composition gazeuse H₂:N₂:HCl

L'épaisseur déposée par HVPE est 800 µm. La séparation de la couche épaisse de GaN plan A et du substrat de saphir plan R est constatée après croissance HVPE. Seules quelques traces de silicium subsistent sur la face arrière de la couche de nitrure autosupportée ; ces traces peuvent être éliminées par attaque chimique.

## Revendications

1. Procédé de réalisation d'un substrat autosupporté de nitrure d'élément III à partir d'un substrat de départ, par dépôt de nitrure d'élément III par épitaxie, **caractérisé en ce qu'**il comporte l'utilisation, sur ledit substrat de départ, d'une couche intermédiaire à base de silicium, à titre de couche sacrificielle destinée à être vaporisée spontanément lors de l'étape ultérieure d'épitaxie du nitrure d'élément III, l'épaisseur de la couche intermédiaire dépendant des conditions de croissance utilisées pour l'épaississement de la couche de nitrure d'élément III.

2. Procédé selon la revendication 1, **caractérisé en ce que** le nitrure d'élément III est choisi parmi AlN, AlₓGa₁₋ₓN, InₓGa₁₋ₓN et AlₓGa_{y}In_{1-x-y}N (avec 0≤x+y≤1).

3. Procédé selon la revendication 2, **caractérisé en ce que** le nitrure d'élément III est le nitrure de gallium.

4. Procédé selon l'une quelconque des revendications 1 à 3, **caractérisé en ce que** la couche intermédiaire à base de silicium est du silicium, du silicium comprenant des impuretés choisies parmi l'aluminium, l'indium, le gallium, le phosphore, le bore ou encore du SiGe.

5. Procédé selon l'une quelconque des revendications 1 à 4, **caractérisé en ce que** la couche intermédiaire à base de silicium est obtenue par dépôt ou par collage sur le substrat.

6. Procédé selon l'une quelconque des revendications 1 à 5, **caractérisé en ce que** la couche intermédiaire à base de silicium est une couche monocristalline de silicium orientée suivant les directions <111>, <110> ou <100>.

7. Procédé selon la revendication 6, **caractérisé en ce que** la couche monocristalline de silicium est épitaxiée suivant la direction <111>.

8. Procédé selon l'une quelconque des revendication 1 à 7, **caractérisé en ce que** la couche intermédiaire à base de silicium se présente sous forme continue, discontinue ordonnée ou discontinue désordonnée.

9. Procédé selon l'une quelconque des revendications 1 à 8, **caractérisé en ce que** la couche intermédiaire à base de silicium a une épaisseur comprise entre 100 nm et 10 µm.

10. Procédé selon l'une quelconque des revendications 1 à 9, **caractérisé en ce que** l'on dépose une couche de nitrure d'élément III d'une épaisseur supérieure à 50 µm.

11. Procédé selon l'une quelconque des revendications 1 à 10, **caractérisée en ce que** le substrat est choisi parmi le saphir, SiC, quartz, MgAl₂O₄, AlN et GaN ou une combinaison de ces derniers.

12. Procédé selon l'une quelconque des revendications 1 à 11, **caractérisé en ce que** le substrat est le saphir.

13. Procédé selon l'une quelconque des revendications 1 à 12, **caractérisé en ce que** le substrat est le saphir selon le plan C (0001) ou le plan R (10-12) ou le plan M(1-100).

14. Procédé selon l'une quelconque des revendications 1 à 13, **caractérisé en ce qu'**une couche de nucléation choisie parmi AlN, SiC, GaN basse température, AlGaN, AlₓGa_{y}In_{1-x-y}N (où 0≤x+y≤1), Al₂O₃, AlAs, GaAs ou la combinaison de ces différentes couches, est déposée sur la couche sacrificielle à base de silicium préalablement à la croissance épitaxiale de nitrure d'élément III.

15. Procédé selon la revendication 14, **caractérisé en ce qu'**une couche de nitrure d'élément III initiale est déposée sur la couche de nucléation, préalablement à la croissance du nitrure d'élément III massif.

16. Procédé selon la revendication 15, **caractérisé en ce que** les épaisseurs de la couche de nucléation définie à la revendication 14 et celle de la couche initiale de nitrure d'élément III définie à la revendication 15 sont comprises respectivement entre 0,01 et 0.5 µm et entre 0,1 et 10 µm.

17. Procédé selon la revendication 16, **caractérisé en ce que** la vitesse de croissance de la couche de nucléation définie à la revendication 14 et la couche initiale de nitrure d'élément III définie à la revendication 15 est comprise entre 0,01 et 3 µm/h.

18. Procédé selon l'une quelconque des revendications 1 à 17, **caractérisé en ce qu'**il comporte les étapes successives suivantes :
(i) le dépôt ou le collage sur un substrat d'une couche sacrificielle à base de silicium,
(ii) le dépôt d'une couche de nucléation,
(iii) le dépôt par épitaxie d'une couche épaisse de nitrure d'élément III sur la bi-couche {couche intermédiaire à base de silicium / couche de nucléation}, dans des conditions opératoires compatibles avec une vaporisation spontanée de la couche sacrificielle à base de silicium.

19. Procédé selon l'une quelconque des revendications 1 à 18, **caractérisé en ce que** les conditions de croissance de la couche épaisse de nitrure d'élément III sont définies par les paramètres suivants, pris séparément ou préférentiellement en combinaison :
- la pression est comprise entre 10² et 10⁵ Pa,
- la température est comprise entre 800°C et 1200°C,
- la vitesse de croissance est comprise entre 10 et 200 µm/h.

20. Procédé selon l'une quelconque des revendications 1 à 19, **caractérisé en ce que** la couche de nucléation peut être déposée, dans le cas où la couche sacrificielle n'est pas continue, soit exclusivement sur la couche sacrificielle, soit exclusivement sur les parties de substrat non recouvertes par la couche sacrificielle, soit sur toute la surface de la couche sacrificielle et des parties nues du substrat.

21. Procédé selon l'une quelconque des revendications 1 à 20, **caractérisé en ce que** le procédé comporte une étape supplémentaire d'élimination des résidus de la couche intermédiaire à base de silicium subsistant après l'étape de croissance de la couche de nitrure d'élément III, par attaque chimique de cette couche intermédiaire à base de silicium.

22. Procédé selon l'une quelconque des revendications 1 à 21, **caractérisé en ce qu'**une partie ou l'intégralité de la croissance de la couche de nitrure d'élément III est réalisée par épitaxie en phase vapeur, par EPVOM ou par HVPE, l'EPVOM pouvant être substituée par l'EJM.

23. Procédé selon l'une quelconque des revendications 1 à 22, **caractérisé en ce que** la couche de nitrure d'élément III est déposée en deux temps, un premier temps à basse vitesse de croissance selon une technique EPVOM ou EJM et un deuxième temps d'épaississement de la couche par une technique HVPE.

24. Procédé selon la revendication 23, **caractérisé en ce que** la couche de nitrure de d'élément III déposée dans le premier temps défini dans la revendication 23, est déposée à une vitesse comprise entre 0,1 et 5 µm/h.

25. Procédé selon l'une quelconque des revendications 1 à 24, **caractérisé en ce que** le nitrure d'élément III peut être dopé par une substance dopante pouvant être choisie dans le groupe constitué par le magnésium, le zinc, le béryllium, le calcium, le carbone, le bore, le chrome, le silicium et le fer.

26. Procédé selon l'une quelconque des revendications 1 à 25, **caractérisé en ce que** la couche de nitrure d'élément III est un substrat autosupporté de nitrure d'élément III de diamètre supérieur ou égal à 2" et de rayon de courbure supérieur à 5 m.

27. Substrat autosupporté de nitrure d'élément III susceptible d'être obtenu selon l'une quelconque des revendications 1 à 25, **caractérisé en ce que** son diamètre est supérieur ou égal à 2" et **en ce qu'**il possède un rayon de courbure supérieur ou égal à 10 m.

## Claims

1. A method for producing a freestanding group-III-nitride substrate from a starting substrate, by the deposition of a group-III nitride by epitaxy, **characterized in that** it includes the use, on said starting substrate, of a silicon-based intermediate layer as a sacrificial layer intended to be vaporized spontaneously during the later step of the epitaxy of the group-III nitride, the thickness of the intermediate layer depending on the growth conditions used for the thickening of the group-III nitride layer.

2. The method according to claim 1, **characterized in that** the group-III nitride is selected among AlN, AlₓGa₁₋ₓN, InₓGa₁₋ₓN and AlₓGa_{y}In_{1-x-y}N (where 0 ≤ x+y ≤ 1).

3. The method according to claim 2, **characterized in that** the group-III nitride is gallium nitride.

4. The method according to any one of the claims 1 to 3, **characterized in that** the silicon-based intermediate layer is of silicon, of silicon that includes impurities chosen among aluminum, indium, gallium, phosphorus and boron, or of SiGe.

5. The method according to any one of the claims 1 to 4, **characterized in that** the silicon-based intermediate layer is obtained by deposition or by bonding on the substrate.

6. The method according to any one of the claims 1 to 5, **characterized in that** the silicon-based intermediate layer is a single-crystal silicon layer oriented according to the direction <111>, <110> or <100>.

7. The method according to claim 6, **characterized in that** the single-crystal silicon layer is grown epitaxially according to the direction <111>.

8. The method according to any one of the claims 1 to 7, **characterized in that** the silicon-based intermediate layer is in continuous, discontinuous ordered or discontinuous disordered form.

9. The method according to any one of the claims 1 to 8, **characterized in that** the silicon-based intermediate layer has a thickness that lies in the range between 100 nm and 10 µm.

10. The method according to any one of the claims 1 to 9, **characterized in that** a group-III-nitride layer of a thickness greater than 50 µm is deposited.

11. The method according to any one of the claims 1 to 10, **characterized in that** the substrate is selected among sapphire, SiC, quartz, MgAl₂O₄, A1N and GaN or a combination thereof.

12. The method according to any one of the claims 1 to 11, **characterized in that** the substrate is sapphire.

13. The method according to any one of the claims 1 to 12, **characterized in that** the substrate is sapphire according to the C-plane (0001) or the R-plane (10-12) or the M-plane (1-100).

14. The method according to any one of the claims 1 to 13, **characterized in that** a nucleation layer chosen among A1N, Sic low-temperature GaN, AlGaN, AlₓGa_{y}In_{1-x-y}N (where 0 ≤ x+y ≤ 1), Al₂O₃, AlAs, GaAs or a combination of these various layers is deposited on the silicon-based sacrificial layer before the epitaxial growth of the group-III nitride.

15. The method according to claim 14, **characterized in that** an initial group-III-nitride layer is deposited on the nucleation layer before the growth of the bulk group-III nitride.

16. The method according to claim 15, **characterized in that** the thicknesses of the nucleation layer defined in claim 14 and that of the initial group-III-nitride layer defined in claim 15 lie between 0.01 and 0.5 µm, and 0.1 and 10 µm, respectively.

17. The method according to claim 16, **characterized in that** the growth rate of the nucleation layer defined in claim 14 and the initial group-III-nitride layer defined in claim 15 lie between 0.01 and 3 µm/h.

18. The method according to any one of the claims 1 to 17, **characterized in that** it comprises the following successive steps:
(i) the deposition or the bonding on a substrate of a silicon-based sacrificial layer,
(ii) the deposition of a nucleation layer,
(iii) the deposition by epitaxy of a thick layer of the group-III-nitride on the bilayer (silicon-based intermediate layer/nucleation layer), under operating conditions compatible with a spontaneous vaporization of the silicon-based sacrificial layer.

19. The method according to any one of the claims 1 to 18, **characterized in that** the growth conditions of the thick layer of the group-III nitride are defined by the following parameters, taken separately or preferentially in combination:
- the pressure lies in the range between 10² and 10⁵ Pa,
- the temperature lies in the range between 800 °C and 1200 °C,
- the growth rate lies in the range between 10 and 200 µm/h.

20. The method according to any one of the claims 1 to 19, **characterized in that** the nucleation layer can be deposited, in the case when the sacrificial layer is not continuous, either exclusively on the sacrificial layer, or exclusively on the areas of the substrate not covered by the sacrificial layer, or over the entire surface of the sacrificial layer and the bare areas of the substrate.

21. The method according to any one of the claims 1 to 20, **characterized in that** the method includes an additional step of the elimination of the residues of the silicon-based intermediate layer that remain after the group-III-nitride layer growth step by chemical etching of this silicon-based intermediate layer.

22. The method according to any one of the claims 1 to 21, **characterized in that** part or all of the growth of the group-III-nitride layer is carried out by vapor phase epitaxy, HVPE or MOVPE, with MOVPE able to be substituted by MBE.

23. The method according to any one of the claims 1 to 22, **characterized in that** the group-III-nitride layer is deposited in two steps, a first step at a low growth rate according to a MOVPE or MBE technique, and a second step of the thickening of the layer by a HVPE technique.

24. The method according to the claim 23, **characterized in that** the group-III-nitride layer deposited in the first step defined in claim 23 is deposited at a speed that lies in the range between 0.1 and 5 µm/h.

25. The method according to any one of the claims 1 to 24, **characterized in that** the group-III nitride can be doped by a doping material able to be selected from the group comprising magnesium, zinc, beryllium, calcium, carbon, boron, chromium, silicon and iron.

26. The method according to any one of the claims 1 to 25, **characterized in that** the group-III nitride layer is a freestanding substrate of group-III nitride possessing a diameter equal to or greater than 2" and possessing a radius of curvature greater than 5 m.

27. A freestanding substrate of group-III nitride likely to be obtained according to any one of the claims 1 to 25, **characterized in that** its diameter is equal to or greater than 2" and **in that** it possesses a radius of curvature greater than or equal to 10 m.

## Patentansprüche

1. Verfahren zur Realisierung eines selbst tragenden Substrats aus Nitrid mit Elementen der 3. Hauptgruppe anhand eines Ausgangssubstrats durch Ablagerung von Nitrid mit Elementen der 3. Hauptgruppe durch Epitaxie, **dadurch gekennzeichnet, dass** es auf dem Ausgangssubstrat die Verwendung einer Zwischenschicht auf Basis von Silizium als Opferschicht umfasst, die dazu dient, spontan beim Schritt nach der Epitaxie des Nitrids mit Elementen der 3. Hauptgruppe zerstäubt zu werden, wobei die Dicke der Zwischenschicht von den Bedingungen des Wachstums abhängt, die für die Eindickung der Schicht aus Nitrid mit Elementen der 3. Hauptgruppe eingesetzt werden.

2. Verfahren nach Anspruch 1, **dadurch gekennzeichnet, dass** das Nitrid mit Elementen der 3. Hauptgruppe unter AlN, AlₓGa₁₋ₓN, InₓGa₁₋ₓN und AlₓGa_{y}In_{1-x-y}N (mit 0 ≤ x+y ≤ 1) ausgewählt wird.

3. Verfahren nach Anspruch 2, **dadurch gekennzeichnet, dass** das Nitrid mit Elementen der 3. Hauptgruppe das Gallium-Nitrid ist.

4. Verfahren nach einem der Ansprüche 1 bis 3, **dadurch gekennzeichnet, dass** die Zwischenschicht auf Basis von Silizium Silizium ist, wobei das Silizium Begleitelemente umfasst, die unter dem Aluminium, dem Indium, dem Gallium, dem Phosphor, dem Bor oder auch dem SiGe ausgewählt werden.

5. Verfahren nach einem der Ansprüche 1 bis 4, **dadurch gekennzeichnet, dass** die Zwischenschicht auf Basis von Silizium durch Ablagerung oder durch Verkleben auf dem Substrat erhalten wird.

6. Verfahren nach einem der Ansprüche 1 bis 5, **dadurch gekennzeichnet, dass** die Zwischenschicht auf Basis von Silizium eine monokristalline Schicht aus Silizium ist, die nach den Richtungen <111>, <110> oder <100> orientiert ist.

7. Verfahren nach Anspruch 6, **dadurch gekennzeichnet, dass** die monokristalline Schicht aus Silizium nach der Richtung <111> epitaxiert ist.

8. Verfahren nach einem der Ansprüche 1 bis 7, **dadurch gekennzeichnet, dass** die Zwischenschicht auf Basis von Silizium eine kontinuierliche, geordnete diskontinuierliche oder ungeordnete diskontinuierliche Form aufweist.

9. Verfahren nach einem der Ansprüche 1 bis 8, **dadurch gekennzeichnet, dass** die Zwischenschicht auf Basis von Silizium eine Dicke zwischen 100 nm und 10 µm aufweist.

10. Verfahren nach einem der Ansprüche 1 bis 9, **dadurch gekennzeichnet, dass** eine Schicht aus Nitrid mit Elementen der 3. Hauptgruppe mit einer Dicke von mehr als 50 µm abgelagert wird.

11. Verfahren nach einem der Ansprüche 1 bis 10, **dadurch gekennzeichnet, dass** das Substrat unter dem Saphir, dem SiC, dem Quarz, dem MgAl₂O₄, dem AlN und dem GaN oder einer Verbindung dieser letzten ausgewählt wird.

12. Verfahren nach einem der Ansprüche 1 bis 11, **dadurch gekennzeichnet, dass** das Substrat der Saphir ist.

13. Verfahren nach einem der Ansprüche 1 bis 12, **dadurch gekennzeichnet, dass** das Substrat der Saphir nach der Fläche C (0001) oder der Fläche R (10-12) oder der Fläche M (1-100) ist.

14. Verfahren nach einem der Ansprüche 1 bis 13, **dadurch gekennzeichnet, dass** eine Nukleationsschicht ausgewählt unter AlN, SiC, Niedertemperatur-GaN, AlGaN, AlₓGa_{y}In_{1-x-y}N (wobei 0≤ x+y ≤ 1), Al₂O₃, AlAs, GaAs oder die Verbindung dieser verschiedenen Schichten, auf der Opferschicht auf Basis von Silizium vor dem epitaxialen Wachstum von Nitrid mit Elementen der 3. Hauptgruppe abgelagert wird.

15. Verfahren nach Anspruch 14, **dadurch gekennzeichnet, dass** eine Anfangsschicht aus Nitrid mit Elementen der 3. Hauptgruppe auf der Nukleationsschicht vor dem Wachstum des massiven Nitrids mit Elementen der 3. Hauptgruppe abgelagert wird.

16. Verfahren nach Anspruch 15, **dadurch gekennzeichnet, dass** die Dicken der Nukleationsschicht, die im Anspruch 14 definiert ist, und der Anfangsschicht aus Nitrid mit Elementen der 3. Hauptgruppe, die im Anspruch 15 definiert ist, jeweils zwischen 0,01 und 0,5 µm und zwischen 0,1 und 10 µm liegen.

17. Verfahren nach Anspruch 16, **dadurch gekennzeichnet, dass** die Geschwindigkeit des Wachstums der Nukleationsschicht, die im Anspruch 14 definiert ist, und der Anfangsschicht aus Nitrid mit Elementen der 3. Hauptgruppe, die im Anspruch 15 definiert ist, zwischen 0,01 und 3 µm/h liegt.

18. Verfahren nach einem der Ansprüche 1 bis 17, **dadurch gekennzeichnet, dass** es die nachstehenden aufeinander folgenden Schritte umfasst:
(i) die Ablagerung oder das Verkleben auf einem Substrat einer Opferschicht auf Basis von Silizium,
(ii) die Ablagerung einer Nukleationsschicht,
(iii) der Ablagerung durch Epitaxie einer dicken Schicht aus Nitrid mit Elementen der 3. Hauptgruppe auf der Bischicht {Zwischenschicht auf Basis von Silizium / Nukleationsschicht}, und dies unter Verfahrensbedingungen, die mit einer spontanen Zerstäubung der Opferschicht auf Basis von Silizium kompatibel sind.

19. Verfahren nach einem der Ansprüche 1 bis 18, **dadurch gekennzeichnet, dass** die Bedingungen des Wachstums der dicken Schicht aus Nitrid mit Elementen der 3. Hauptgruppe durch die nachstehenden Parameter definiert sind, die getrennt oder vorzugsweise in Verbindung miteinander genommen werden:
- der Druck liegt zwischen 10² und 10⁵ Pa,
- die Temperatur liegt zwischen 800 °C und 1200 °C,
- die Geschwindigkeit des Wachstums liegt zwischen 10 und 200 µm/h.

20. Verfahren nach einem der Ansprüche 1 bis 19, **dadurch gekennzeichnet, dass**, in dem Fall, in dem die Opferschicht nicht kontinuierlich ist, die Nukleationsschicht entweder ausschließlich auf der Opferschicht, oder ausschließlich auf den Teilen des Substrats, die nicht von der Opferschicht überdeckt sind, oder auf der gesamten Oberfläche der Opferschicht und der bloßen Teile des Substrats abgelagert werden kann.

21. Verfahren nach einem der Ansprüche 1 bis 20, **dadurch gekennzeichnet, dass** das Verfahren einen zusätzlichen Schritt zur Beseitigung der Rückstände der Zwischenschicht auf Basis von Silizium umfasst, die noch nach dem Schritt des Wachstums der Schicht aus Nitrid mit Elementen der 3. Hauptgruppe bestehen, und dies durch chemischen Angriff dieser Zwischenschicht auf Basis von Silizium.

22. Verfahren nach einem der Ansprüche 1 bis 21, **dadurch gekennzeichnet, dass** ein Teil oder die Gesamtheit des Wachstums der Schicht aus Nitrid mit Elementen der 3. Hauptgruppe durch Epitaxie in der Dampfphase durch die MOVPE oder durch die HVPE realisiert wird, wobei die MOVPE durch die MBE ersetzt werden kann.

23. Verfahren nach einem der Ansprüche 1 bis 22, **dadurch gekennzeichnet, dass** die Schicht aus Nitrid mit Elementen der 3. Hauptgruppe in zwei Schritten abgelagert wird, ein erster Schritt bei niedriger Geschwindigkeit des Wachstums anhand einer MOVPE- oder MBE-Technik und ein zweiter Schritt der Eindickung der Schicht anhand einer HVPE-Technik.

24. Verfahren nach Anspruch 23, **dadurch gekennzeichnet, dass** die Schicht aus Nitrid mit Elementen der 3. Hauptgruppe, die im ersten in Anspruch 23 definierten Schritt abgelagert wird, mit einer Geschwindigkeit zwischen 0,1 und 5 µm/h abgelagert wird.

25. Verfahren nach einem der Ansprüche 1 bis 24, **dadurch gekennzeichnet, dass** das Nitrid mit Elementen der 3. Hauptgruppe kann mittels einer Dopsubstanz gedopt werden kann, die in der Gruppe ausgewählt werden kann, die sich aus dem Magnesium, dem Zink, dem Beryllium, dem Kalzium, dem Kohlenstoff, dem Bor, dem Chrom, dem Silizium und dem Eisen zusammen setzt.

26. Verfahren nach einem der Ansprüche 1 bis 25, **dadurch gekennzeichnet, dass** die Schicht aus Nitrid mit Elementen der 3. Hauptgruppe ein selbst tragendes Substrat aus Nitrid mit Elementen der 3. Hauptgruppe mit einem Durchmesser, der größer als oder gleich 2" ist, und mit einem Krümmungsradius von mehr als 5 m ist.

27. Selbst tragendes Substrat aus Nitrid mit Elementen der 3. Hauptgruppe, das nach einem der Ansprüche 1 bis 25 erhalten werden kann, **dadurch gekennzeichnet, dass** sein Durchmesser größer als oder gleich 2" ist und **dadurch**, dass es einen Krümmungsradius aufweist, der größer als oder gleich 10 m ist.
